(19) Europäisches Patentamt
European Patent Office
Office européen des brevets

(11) Numéro de publication: **0 014 647**
**B1**

(12) **FASCICULE DE BREVET EUROPEEN**

(45) Date de publication du fascicule du brevet: **29.06.83**

(51) Int. Cl.³: **G 11 C 27/00**, G 06 G 7/19

(21) Numéro de dépôt: **80400161.8**

(22) Date de dépôt: **01.02.80**

(54) **Dispositif acousto-électrique à deux dimensions pour la mémorisation et le traitement d'information.**

(30) Priorité: **02.02.79 FR 7902766**

(43) Date de publication de la demande:
**20.08.80 Bulletin 80/17**

(45) Mention de la délivrance du brevet:
**29.06.83 Bulletin 83/26**

(84) Etats contractants désignés:
**DE GB**

(56) Documents cités:
**US - A - 3 931 509**
**US - A - 3 935 564**
**US - A - 4 114 116**

(73) Titulaire: **THOMSON-CSF**
**173, Boulevard Haussmann**
**F-75379 Paris Cedex 08 (FR)**

(72) Inventeur: **Maerfeld, Charles**
**"THOMSON-CSF" SCPI 173, bld Haussmann**
**F-75360 Paris Cedex 08 (FR)**
Inventeur: **Gautier, Hervé**
**"THOMSON-CSF" - SCPI 173, bld Haussmann**
**F-75360 Paris Cedex 08 (FR)**

(74) Mandataire: **Benoit, Monique et al,**
**THOMSON-CSF SCPI 173, Bld Haussmann**
**F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

**EP 0 014 647 B1**

# Dispositif acousto-électrique à deux dimensions pour la mémorisation et le traitement d'information

La présente invention a pour objet un dispositif acousto-électrique capable de stocker l'information, sous forme analogique, en un point quelconque d'une surface, et de réaliser sur cette information différents traitements, comme la transformation de Fourier par exemple.

Différents dispositifs acousto-électriques ont déjà été utilisés pour la mémorisation et le traitement d'information. Ils sont généralement constitués par un substrat piézoélectrique et un substrat semiconducteur placés en vis-à-vis; des ondes acoustiques, également appelées ondes élastiques, sont engendrées à la surface du substrat piézoélectrique; leurs interactions créent des domaines spatialement différenciés qui les représentent et qui sont mémorisés dans le substrat semiconducteur. D'autres ondes acoustiques sont ultérieurement engendrées à la surface du substrat piézoélectrique et interagissent avec l'information mémorisée, réalisant ainsi un traitement de l'information portée par les ondes élastiques, tel que corrélation ou convolution. Un tel dispositif est par exemple décrit dans le brevet français n° 73-45234 au nom de Thomson-CSF (n° de publication: 2 254 908), ou dans le brevet américain n° 3 935 564.

Toutefois, la mémorisation et le traitemtnt ne s'effectuent dans ces dispositifs que selon une seule dimension. Le dispositif suivant le brevet américain 3 935 564 nécessite l'utilisation de deux commutateurs électriques permettant de sélectionner une zone d'interactions parmi plusieurs, arrangés en matrice dans un milieu piézoélectrique à deux dimensions.

La présente invention a pour objet un dispositif de mémorisation d'informations analogiques en des points quelconques mais distincts d'une surface à deux dimensions, et le traitement de ces informations, ce qui présente des avantages évidents de compacité du dispositif, ainsi que de simplification dans la réalisation de certains traitements, qui seront décrits ci-dessous.

A cet effet, le dispositif selon l'invention comporte:

— un milieu piézoélectrique portant au moins deux transducteurs électromécaniques, susceptibles d'émettre des ondes élastiques à la surface du millieu piézoélectrique;
— un milieu électriquement non linéaire dans lequel sont susceptibles de se produire des interactions non linéaires entre les champs électriques associés aux ondes élastiques se propageant sur le millieu piézoélectrique;
— un milieu de stockage de charges électriques, ce milieu étant électriquement couplé au milieu non linéaire et susceptible de mettre en mémoire un signal analogique;
— un dispositif d'application et de prélèvement d'un signal électrique;

ce dispositif étant caractérisé par le fait que la mise en mémoire d'un signal analogique d'entrée est réalisée à l'aide de deux signaux auxiliaires d'écriture, deux de ces trois signaux étant appliqués sur deux transducteurs électromécaniques qui émettent des ondes élastiques dans deux directions distinctes à l'exclusion des sens opposés et l'autre signal étant appliqué sur un troisième transducteur électromécanique ou sur le dispositif d'application d'un signal électrique qui agit sur la surface d'interaction, les fréquences des signaux auxiliaires étant telles que l'interaction non linéaire des trois signaux fournisse un signal représentant le signal d'entrée, indépendant du temps, sous forme d'une distribution spatiale périodique de charges électriques, stockées dans le milieu de stockage, les deux signaux auxiliaires d'écriture étant des trains d'impulsions, d'amplitude supérieure à celle du signal d'entrée, la surface d'intersection de ces deux impulsions définissant une zone élémentaire d'interaction, ces impulsions étant émises avec une période au moins égale au temps de balayage de la surface d'interaction par la zone élémentaire, et des retards relatifs variables, assurant le balayage en lignes de la surface d'interaction par la zone élémentaire et par suite le stockage en lignes du signal résultant des interactions non linéaires successives.

Le signal ainsi mémorisé est ultérieurement traité à l'aide de deux, trois ou quatre signaux auxiliaires de lecture qui, selon leur fréquence, leur forme et leur direction d'émission, fournissent le traitement du signal S(t) notamment par corrélation, convolution ou transformée de Fourier.

D'autres objets, caractéristiques et résultats de l'invention apparaîtront dans la description suivante et les dessins annexés, où:

— la figure 1 représente un mode de réalisation du dispositif selon l'invention;
— la figure 2 est un schéma explicatif du fonctionnement du dispositif selon l'invention;
— la figure 3 représente une vue en coupe fractionnaire d'une variante de réalisation de la figure 1.

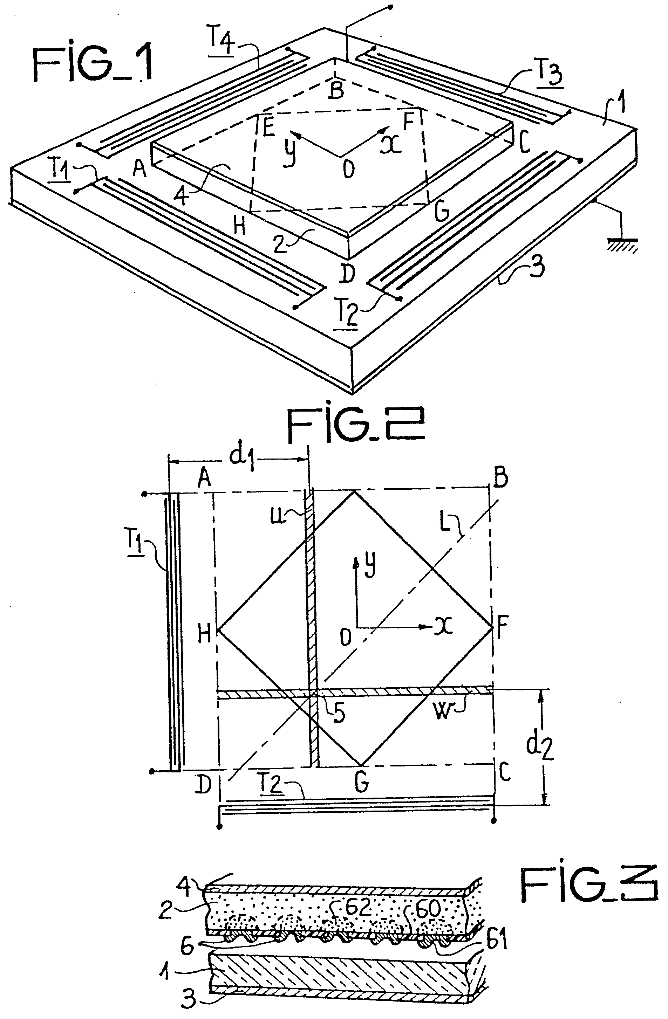

La figure 1 comporte:
— un substrat piezoélectrique 1, par exemple en forme de plaquette rectangulaire;
— quatre transducteurs électro-mécaniques: $T_1$, $T_2$, $T_3$ et $T_4$, capables d'émettre une excitation électrique des ondes élastiques à la surface du substrat 1 et réciproquement, et cela dans deux directions distinctes Ox et Oy qui sont, dans l'exemple de la figure, perpendiculaires entre elles. Les transducteurs sont par exemple chacun constitués, classiquement, par deux électrodes en forme de

peignes à dents alternées, les ondes étant émises dans la direction qui est normale aux dents des peignes. Sur la figure. les transducteurs $T_1$ et $T_3$ émettent des ondes respectivement selon $+\overrightarrow{Ox}$ et $-\overrightarrow{Ox}$ et les transducteurs $T_2$ et $T_4$ selon $+\overrightarrow{Oy}$ et $-\overrightarrow{Oy}$. La zone ABCD d'intersection des ondes élastiques est appelée surface d'interaction; si les transducteurs ont même longueur et sont placés deux à deux en vis-à-vis, ABCD est, comme représenté sur la figure, un carré dont le côté est égal à la longueur des transducteurs;

— un milieu dit non linéaire, dans lequel sont susceptibles de se produire des interactions non linéaires entre les signaux appliqués au dispositif, interactions dont l'amplitude dépend de la concentration des charges électriques dans le milieu. Ce milieu est soit continu et homogène, soit constitué d'éléments discrets, tels que des diodes. Dans le premier cas, il est de préférence semi-conducteur, par exemple en silicium. Dans le mode de réalisation représenté sur la figure, ce milieu semi-conducteur se présente sous forme d'une plaquette 2, placée en vis-à-vis du substrat 1, du côté des transducteurs et selon la surface d'interaction, et la plaquette 2 est séparée du substrat 1 par une mince couche d'air.

— des moyens permettant de stocker des quantités de charges, électriquement couplés au milieu non linéaire. Ces moyens sont constitués soit par un milieu continu, tel qu'un substrat semi-conducteur dans lequel il existe des pièges de surface ou de volume pour les porteurs de charges, soit par un réseau d'éléments de mémoire discrets, tel qu'un réseau de capacités réalisées dans le milieu semi-conducteur 2. Ces moyens ne sont pas représentés sur la figure 1, mais sont décrits plus en détail ci-dessous.

— des moyens de prélèvement ou d'application de signaux électriques, produits par le dispositif ou appliqués à lui. Ces moyens peuvent être constitués simplement par une électrode 3, dite de masse, continue, reliée au potentiel de référence du dispositif, recouvrant la surface du substrat 1 opposée à celle qui porte les transducteurs, et une électrode 4 dite de signal, de structure continue ou périodique, placée sur la surface du substrat 2 qui est opposée à la surface d'interation. Par ailleurs, différentes variantes, non représentées, sont possibles pour la réalisation des substrats semi-conducteur et piezoélectrique: il est possible de confondre les deux milieux en un seul substrat, en sulfure de cadmium (CdS) ou arséniure de gallium (AsGa) par exemple, ou encore de réaliser le milieu piezoélectrique par une couche mince, c'est-à-dire dont l'épaisseur est de l'ordre d'une fraction de la longueur d'onde élastique, déposée sur une plaquette de matériau semi-conducteur.

Pour mettre en mémoire un signal dans le dispositif de la figure 1, on utilise deux signaux auxiliaires d'écriture de la façon suivante.

On suppose que le signal S(t) à mémoriser est d'une durée inférieure au temps de parcours de la surface d'interation par une onde élastique et qu'il est porté par une onde de pulsation $\omega_s$, et que les deux signaux d'écriture, U(t) et W(t) sont respectivement des ondes de pulsation $\omega_u$ et $\omega_w$.

On applique par exemple le signal U(t) au transducteur $T_1$, le signal W(t) au transducteur $T_2$ et le signal S(t) entre les deux électrodes 3 et 4. Les ondes émises peuvent s'écrire:

— pour $T_1$: $U(t)\cos(\omega_u t-\vec{k}_u\,.\,\vec{r})$
— pour $T_2$: $W(t)\cos(\omega_w t-\vec{k}_w\,.\,\vec{r})$
— pour les électrodes 3 et 4: $S(t)\cos(\omega_s t-\vec{k}_s\,.\,\vec{r})$

avec les remarques suivantes:

— $\vec{k}_u$ et $\vec{k}_w$ sont les vecteurs d'ondes correspondant aux ondes émises;
— $\vec{k}_s$ n'est pas un vrai vecteur d'onde, mais un vecteur perpendiculaire aux électrodes 3 et 4, de module

$$\frac{2\pi}{p}$$

dans le cas où l'électrode 3 est un réseau périodique de pas p; das le cas où l'électrode 3 est continue, $|\vec{k}_s|=0$;
— r détermine le point de coordonnées (x, y);
— l'origine des temps et des coordonnées est le point O, situé au milieu de la zone d'interaction.

Du fait de la nature piezoélectrique du substrat 1, un potentiel est associé aux ondes élastiques de surface; il existe alors, au moment de l'interaction de ces trois ondes dans le milieu non linéaire 2, le potentiel suivant:

$$V=U\cos(\omega_u t-\vec{k}_u\,.\,\vec{r})+W\cos(\omega_w t-\vec{k}_w\,.\,\vec{r})+S\cos(\omega_s t-\vec{k}_s\,.\,\vec{r}) \quad (1)$$

Le milueu 2 est électriquement non linéaire, c'est-à-dire que la caractéristique $I_s=f(V_s)$ entre le potentiel

($V_s$) appliqué à la surface du milieu 2 et le courant ($I_s$) normal à sa surface, n'est pas linéaire, mais est de la forme:

$$I_s=Y_{sc}V_s+\frac{\partial Y_{sc}}{\partial V_s}.V_s^2+\frac{\partial^2 Y_{sc}}{\partial V_s^2}.V_s^3+\ldots$$

$$=i_L+i_{NL2}+i_{NL3}+\ldots \qquad (2)$$

où $Y_{sc}$ est l'admittance de surface du semi-conducteur 2 par unité de surface, et

$$\frac{\partial Y_{sc}}{\partial V_s} \text{ et } \frac{\partial^2 Y_{sc}}{\partial V_s}$$

traduisent la modification de cette admittance en fonction du potentiel de polarisation $V_s$. Les courants $i_L$, $i_{NL2}$, $i_{NL3}$ sont les courants résultants, respectivement linéaire, non linéaire d'ordre 2 et non linéaire d'ordre 3.

A titre d'exemple, le milieu non linéaire peut être un substrat semi-conducteur homogène: en effet, on sait qu'il existe à la surface d'un semi-conducteur une zone enrichie ou appauvrie en électrons par rapport au rest du volume de ce semi-conducteur; il en résulte l'apparition d'une capacité de surface dont la valeur peut être, selon des théories bien connues (effect varicap), modifiée par l'existence d'un potentiel de surface. Ce potentiel peut être par exemple créé par une onde élastique se déplaçant à la surface d'un milieu piezoélectrique proche du milieu semi-conducteur. Il se produit alors une mémorisation de ce potentiel représentant l'onde élastique.

Comme milieu non linéaire, il est également possible d'utiliser une matrice d'éléments discrets, chacun d'eux ayant une caractéristique du type diode, c'est-à-dire que le courant qui les traverse dans le sens direct est notablement supérieur au courant qui les traverse dans le sens inverse. La surface du milieu semi-conducteur qui est en regard de la surface d'interaction porte dans ce cas par exemple un réseau de diodes. Le potentiel associé aux ondes élastiques se propageant à la surface du milieu piezoélectrique polarise alors ces diodes et, à chaque alternance pour laquelle les diodes sont polarisées en direct, il circule dans le semi-conducteur un courant normal à la surface de celui-ci. Par contre, aucun courant ne circule dans le autres alternances. Il en résulte un déplacement net de charges par période et qui crée un potentiel qui s'oppose au potentiel de polarisation: le courant s'arrête quand le potentiel qui est induit est égal et opposé au maximum du potentiel de polarisation. Ce fonctionnement est celui d'un détecteur de crête. Il est à observer qu'un fonctionnement correct nécessite un nombre de diodes tel que leur espacement soit inférieur à la demi longueur d'onde élastique.

Les modes de fonctionnement décrits ci-dessus comportent une fonction de mémorisation et permettent donc de réaliser en un seul milieu les moyens de stockage et le milieu non linéaire mentionnés ci-dessus. Toutefois, c'est le deuxième mode de fonctionnement qui donne les meilleurs effets de mémoire, et c'est sur celui-ci que repose la description suivante. A titre d'exemple, ce mode de réalisation est illustré sur la figure 3. Néanmoins, le dispositif suivant l'invention peut utiliser l'un ou l'autre des types de milieux non linéaires.

La figure 3 représente donc une vue en coupe partielle d'une variante du dispositif selon l'invention, dans laquelle est utilisé un réseau de diodes comme milieu non linéaire et moyen de stockage.

Sur cette figure, on distingue d'une part le substrat piezoélectrique 1 et l'électrode de masse 3, et d'autre part le substrat semi-conducteur 2 et l'électrode signal 4. La face du semi-conducteur 2 qui est en vis-à-vis du substrat 1 porte un réseau de diodes globalement repérées 6.

Chacune des diodes 6 comporte une zone 62, réalisée dans le substrat 2 d'un type de conductivité opposé à celui du substrat; le substrat 2 est recouvert d'une couche isolante 60 interrompue au droit des zones 62; la diode 6 est terminée par un plot conducteur 61 déposé dans les trous ménagés dans la couche 60.

Les diodes de type PN décrites ci-dessus peuvent être bien entendu remplacées par d'autres éléments semi-conducteurs électriquement non linéaires, comme un autre type de diodes, ou encore par des éléments MOS ou MIS.

En outre, afin d'améliorer l'effet de mémoire, il est possible de réaliser des capacités dans le substrat semi-conducteur 2 et, dans le cas où le milieu non linéaire est constitué par un réseau de diodes, de connecter les capacités en parallèle respectivement avec chacune des diodes.

Ainsi qu'il a été dit ci-dessus, le dispositif selon l'invention fait appel à deux signaux auxiliaires d'adressage U(t) et W(t). Pour généraliser la formule (1), on ne préjuge plus du transducteur qui a émis les signaux U, W ou S: ce transducteur peut être l'un quelconque des transducteurs électro-mécaniques $T_1$ ou $T_2$ ou la paire d'électrodes 3 et 4.

L'interaction non linéaire de ces trois signaux fournit des signaux caractérisés par leur pulsation Ω

et leur vecteur d'onde K résultants. On montre que l'un deux, appelé ici $S_M$, est indépendant du temps (c'est-à-dire que la pulsation $\Omega_M$ est nulle) et peut être utilisé pour mémoriser le signal S(t).

On a donc $\Omega_M=0=\varepsilon_u \cdot \omega_u+\varepsilon_w \cdot \omega_w+\varepsilon_s \cdot \omega_s$ avec $\varepsilon=\mp 1$, $\varepsilon_w=\mp 1$, $\varepsilon_s=\mp 1$, ce qui s'écrit plus simplement: $\varepsilon_u \cdot \omega_u+\varepsilon_w \cdot \omega_w=\omega_s$. Si on pose en outre U>S et W>S, on a:

$$V_{MAX}=U+W=S\cos[(\varepsilon_u\vec{K}_u+\varepsilon_w\vec{K}_w+\varepsilon_s\vec{K}_s)\cdot\vec{r}] \quad (3)$$

c'est-à-dire que le signal S est figé de façon indépendante du temps avec une périodicité spatiale K:

$$\vec{K}=\varepsilon_u\vec{K}_u+\varepsilon_w\vec{K}_w+\varepsilon_s\vec{K}_s$$

ou encore

$$\vec{K}=\varepsilon_u\vec{K}_u+\varepsilon_w\vec{K}_w-\vec{K}_s$$

Si $\omega_u$ n'est pas sensiblement différent de $\omega_w$, la condition liant les pulsations se simplifie en:

$$\omega_s=\omega_u\pm\omega_w \quad (4)$$

et la relation liant les vecteurs d'ondes, en:

$$\vec{K}=\pm(\vec{K}_u\pm\vec{K}_w-\vec{K}_s) \quad (5)$$

Les formules (4) et (5) constituent des règles de sélection liant les signaux S(t), U(t) et W(t), et plus précisément liant leurs fréquences à leurs modes d'application (électrodes 3—4 ou transducteurs $T_1 \ldots T_4$).

Il est à remarquer toutefous que $\omega_u$ et $\omega_w$ ne doivent de préférence pas être trop voisins l'un de l'autre afin d'éviter que ne se forme un battement de U et W donnant naissance à un réseau qui se superpose au réseau de période K.

Par ailleurs, on a supposé un fonctionnement du type détecteur de crête; un comportement non linéaire du premier type décrit aboutit à un résultat très proche, seule l'amplitude des signaux mémorisés étant différente.

En pratique, dans un premier mode de mise en oeuvre du dispositif selon l'invention, on utilise pour mémoriser un signal S(t) deux signaux auxiliaires d'écriture U(t) et W(t) de forme impulsionnelle.

Ils sont par exemple les suivants:

$$U \cdot \delta(t) \cdot e^{i\omega_u t}$$

appliqué sur le transducteur $T_1$, donc émis selon Ox,

$$W \cdot \delta(t-\tau) \cdot e^{i\omega_w t}$$

appliqué sur le transducteur $T_2$, donc émis selon Oy,

$$S(t) \cdot e^{i\omega_s t}$$

appliqué sur les électrodes 3 et 4, $\delta$ étant la fonction de DIRAC.

A un instant t donné, seul un point M de coordonnées:

$$\begin{cases} x=v_x \cdot t \\ y=v_y \cdot t-v_y \cdot \tau \end{cases}$$

voit la présence simultanée des trois ondes. En ce point, les charges q(x, y) des éléments non linéaires sont données par la formule (3) et on obtient:

$$q(x, y)\propto U+W+S(-\frac{x}{V_x}) \cdot \cos\vec{K} \cdot \vec{r}$$

Lorsque t varie, le point M décrit une droite L d'équation:

$$y=\frac{v_y}{v_x} \cdot x-v_u\tau$$

sur laquelle la charge Q(x) est égale à:

$$Q(x) \propto U+W+S\left(-\frac{x}{v_x}\right) . \cos\vec{K} . \vec{r} \qquad (6)$$

En dehors de cette droite L, la charge est égale à l'amplitude maximale des signaux qui ont circulé, soit le plus grand des signaux U ou W, puisqu'on a ici

$$\begin{cases} U>S \\ W>S \end{cases}$$

Pour inscrire une seconde ligne, on utilise à nouveau deux ondes impulsionnelles mais pour lesquelles le retard de la seconde par rapport à la première est maintenant égal à $\tau'$: on applique sur le transducteur $T_1$ le signal

$$U . \delta(t) . e^{i\omega_u t}$$

et sur le transducteur $T_2$:

$$W . \delta(t-\tau') . e^{i\omega_w t}$$

un signal S'(5) à mémoriser étant appliqué sur les électrodes 3 et 4 à la fréquence $\omega_s$ comme précédemment.

De façon analogue à ce qui est décrit précédemment, un seul point M' voit la présence simultanée des trois ondes, ce point M' décrivant une droite L' parallèle à la précédente et d'équation:

$$y=\frac{v_y}{v_x} . x-v_y . \tau'$$

Sur cette droite L' la charge est égale au maximum des signaux U(t), W(t) et S', c'est-à-dire, de façon analogue à la ligne L (équation 6):

$$Q(x) \propto U+W+S'\left(-\frac{x}{v_x}\right)\cos\vec{K} . \vec{r}$$

Cet enregistrement en lignes parallèles est illustré sur la figure 2.

Sur la figure 2 sont représentés seulement le plan XOY et les deux transducteurs $T_1$ et $T_2$ qui émettent les impulsions, ainsi que la surface d'interaction ABCD. On a illustré à un instant t donné la position des ondes élastiques par des bandes hachurées repérées U et W, pour simplifier: l'impulsion U est parallèle à $T_1$ à une distance $d_1$ (égale à $v_x t$) de ce dernier et l'impulsion W est parallèle à $T_2$ à une distance $d_2$[égale à $v_y(t-\tau)$] de ce dernier.

La zone d'intersection 5 de ces deux zones constitue le "point" M précédent. Lorsque les deux impulsions U et W se propagent, leur intersection 5 décrit la droite L. L'angle que fait cette droite avec L avec OX ne dépend que des directions d'émission et des vitesses des ondes U et W. Si, comme représenté sur la figure, U est émis selon Ox et W selon Oy et si $v_x=v_y$, la droite L fait un angle de $\pi/4$ avec Ox. Par ailleurs, comme la position de la ligne L dans le plan XOY dépend du retard $\tau$ de W par rapport à U, on voit qu'il est possible comme montré précédemment par le calcul de balayer une surface telle que ABCD par une trame de N lignes parallèles à la droite L, en émettant N couples d'impusions (U, W) avec N valeurs différentes de leut retard relatif $\tau$.

Il est à noter qu'avec le procédé d'écriture employé, l'inscription d'une ligne n'efface pas l'inscription des lignes précédentes: en effet, il n'y a coïncidence des trois signaux U, W et S que sur la ligne (par exemple L') dont l'inscription est en cours. Sur le reste de la surface, le potentiel maximum existant est égal au plus grand des signaux U ou W, et donc inférieur au potentiel de la ligne préalablement écrite où il ne sera donc pas pris en compte. Réciproquement, l'inscription du plus grand des signaux U ou W sur l'ensemble de la surface d'interaction lors de l'inscription de la ligne L n'empéche pas l'inscription de la ligne L-sur cette méme surface, celle-ci étant caractérisée par un potentiel supérieur à celui y existant préalablement.

Le dispositif de la figure 1 comportant cinq entrées, c'est-à-dire quatre transducteurs électromécaniques ($T_1 \ldots T_4$) et la paire d'électrodes 3—4, il est possible de realiser des variantes de ce premier mode d'écriture utilisant toujours deux ondes auxiliaires impulsionnelles mais appliquées à des entrées différentes.

Par exemple, dans une première variante, on peut utiliser trois ondes de surface. Comme précédemment, on applique les signaux U(t) et W(t) respectivement aux transducteurs $T_1$ et $T_2$ mais les signal S(t) est appliqué non plus aux électrodes 3—4 mais au transducteur $T_3$, et ce avec les mêmes

règles de selection (4) et (5), c'est-à-dire $\omega_s=\omega_u\pm\omega_w$. De la même manière, à un instant t, les trois signaux qui sont maintenant des ondes de surface sont présents en un point M tel que:

$$M\begin{cases}x=v_xt\\y=v_yt-v_y\tau\end{cases}$$

La quantité de charges stockée est alors de la forme, selon la formule (3):

$$q(x,\ y)\propto U+W+S\left(\frac{x}{2v_x}\right).\cos\vec{K}.\ \vec{r}$$

Il est à remarquer, par rapport au cas précédent, le changement de signe de S et la compression par deux du signal mémorisé. Comme précédemment, le signal S(t) s'inscrit, lorsque t varie, sur une ligne L d'équation

$$y=\frac{v_y}{v_x}.\ x-v_y\tau$$

Sur cette ligne L, le signal est energistré avec une périodicité spatiale $\vec{K}$ de composantes:

$$\frac{\omega_u\pm\omega_s}{v_x}\ \text{et}\ \pm\frac{\omega_w}{v_y}$$

Une seconde variante consiste à appliquer le signal S(t) à un transducteur électro-mécanique, par exemple $T_1$, et à appliquer l'un des signaux impulsionnels d'écriture, par exemple W(t), aux électrodes 3 et 4, l'autre signal d'écriture étant appliqué à un transducteur électro-mécanique, par exemple $T_2$, W(t) étant comme précédemment de la forme:

$$W(t):\ W.\ \delta(t-\tau)$$

Il n'y a présence simultanée des trois ondes qu'au temps $t=\tau$ et ce sur la droite d'équation $y=v_y.\ \tau$, qui est maintenant une droite horizontale. La charge mémorisée est alors:

$$Q(x)\propto U+W+S\left(-\frac{x}{v_x}\right).\cos\vec{K}.\ \vec{r}$$

de périodicité spatiale K

$$\frac{-\omega_s}{v_x}$$

$$\frac{\omega_w}{v_y}$$

A la fin de l'écriture, la charge Q(x) est mémorisée dans le milieu de stockage qui est constitué, ainsi qu'il est dit plus haut, par exemple par des pièges de surface dans un semi-conducteur, par un réseau de capacités ou par les capacités internes au réseau de diodes qui constituent le milieu non linéaire. Dans ce dernier cas, les diodes se trouvent à la fin de l'écriture polarisées en inverse; leur courant inverse étant faible, les charges qui s'y trouvent accumulées ne disparaissent que très lentement: à titre d'exemple, il est possible d'atteindre avec les diodes de type PN des durées de stockage de l'ordre de 10 secondes à la température ambiante. On a donc dans le milieu de stockage, pendant toute la durée de ce stockage, une onde figée:

$$S_M=S(x,\ y).\cos\vec{K}.\ \vec{r}$$

plus un potentiel de polarisation égal à U+W.

Dans un premier mode de réalisation, la lecture est réalisée par interaction non linéaire entre l'onde figée $S_M$ et deux ondes auxiliares de lecture N(t) et P(t), de façon analogue au processus d'écriture: elle fait appel au terme $i_{NL3}$ de l'équation (2) ci-dessus:

$$i_{NL3}=\frac{\partial^2 Y_{sc}}{\partial Vs^2}\,.\,V^3 \propto C\,.\,V^3$$

L'onde $S_L$ produite par la lecture a, comme précédemment, pour pulsation

$$\omega_L=\varepsilon_N\omega_N+\varepsilon_P\,.\,\omega_P$$

où

$$\varepsilon_N=\pm 1$$

et

$$\varepsilon_P=\pm 1 \qquad (7)$$

et comme nombre d'onde

$$\vec{K}=\varepsilon_N\vec{K}_N+\varepsilon_P\vec{K}_P\pm\vec{K} \qquad (8)$$

Comme lors de l'écriture, il existe ici une règle de sélection, qui porte maintenant sur les vecteurs d'ondes:

— si le signal de lecture $S_L$ doit être recueilli entre les électrodes 3 et 4, les vecteurs d'ondes doivent être tels que $K_L$ soit nul ou corresponde au pas de l'électrode signal 3 si celle-ci est périodique, c'est-à-dire que

$$|\vec{K}_L|=\frac{2\pi}{p}$$

où p est la périodicité de l'électrode signal, $K_L$ étant perpendiculaire au réseau constitué par l'électrode signal;

— si le signal de lecture $S_L$ doit être recueilli par l'un des transducteurs $T_1 \ldots T_4$, il doit y avoir émission d'une onde élastique, ce qui impose de plus:

$$|\vec{K}_L|=|\vec{K}_N+\varepsilon_p\vec{K}_p\pm\vec{K}|=\left|\frac{\omega_N+\varepsilon_p\,.\,\omega_p}{v}\right|$$

où

$$v=v_x \text{ ou } v_y$$

A titre d'exemple, on donne ci-dessous deux modes de lecture possibles.

Dans une première variante, on applique les signaux N(t) et P(t) auxiliaires de lecture respectivement aux transducteurs $T_1$ et $T_2$:

$$N(t)=N\delta(t)e^{i\omega_N t} \text{ sur } T_1$$

$$P(t)=P\delta(t-\tau)e^{i\omega_P t} \text{ sur } T_2$$

Le signal $S_L$ résultant de l'interaction non linéaire est alors prélevé entre les électrodes 3 et 4; ce signal est de la forme:

$$S_L=e^{i(\omega_N+\varepsilon_P\omega_P)t}\iint S(x,y)\,.\,\delta(t\alpha\frac{x}{V_x})\,.\,\delta(t-\tau-\frac{y}{V_y})\,.\,dx\,.\,dy$$

c'est-à-dire que:

$$S_L \propto S[v_x t,\, v_y(t-\tau)]$$

En d'autres termes, comme lors de l'écriture, le point d'interaction des trois ondes balaye une ligne diagonale d'équation:

$$y=\frac{v_y}{v_x}\,.\,x-v_y\tau$$

De même, en changeant la valeur du retard $\tau$, on lit une autre ligne parallèle à la précédente.

Il est à noter que si l'écriture à été effectuée selon la premier mode de mise en oeuvre décrit, la règle de sélection (5) est automatiquement respectée si$\omega_u=\omega_N$ et si$\omega_W=\omega_P$ et si on a $\omega_L=\omega_N\pm\omega_P$.

Dans une seconde variante, on peut appliquer le même signal N(t) au transducteur $T_1$, le même signal P(t) au transducteur $T_4$: le signal de lecture $S_L$ sera alors disponible aux bornes des électrodes 3 et 4. De la même manière, le point d'interaction des trois ondes balaye alors une ligne diagonale d'équation:

$$y=-\frac{v_y}{v_x}x-v_y\cdot\tau$$

Dans le cas où l'écriture a été effectuée selon le premier mode de mise en oeuvre décrit ci-dessus, ce second mode de lecture permet d'inverser lignes et colonnes de la matrice stockée lors de la lecture, en entendant par lignes les informations enregistrées parallèlement à la ligne (L) précédente.

Il a été ainsi décrit, dans un premier mode de mise en oeuvre du dispositif selon l'invention, un processus d'écriture d'un signal S(t) utilisant deux ondes auxiliaires impulsionnelles d'adressage, puis un processus de lecture utilisant également deux autres ondes auxiliaires impulsionnelles de lecture. On obtient ainsi la mémorisation puis la restitution du signal S(t). Dans un second mode de mise en oeuvre du dispositif selin l'invention, il est possible d'obtenir, après mémorisation du signal d'entrée S(t), une transformée globale de celui-ci, telle que sa transformée de Fourier.

Dans une première variante, on considère le signal précédemment mémorisé

$$S_M=S(x,\ y)\cos\vec{K}\cdot\vec{r}$$

et on utilise les deux signaux de lecture suivants:

$$N(t):\ N\cdot e^{i\omega_N t}$$

appliqué sur le transducteur $T_1$, et

$$P(t):\ P\cdot e^{i\omega_P t}$$

appliqué sur le transducteur $T_2$. Il s'agit non plus de signaux impulsionnels, mais de signaux longs, c'est-à-dire dont la durée est au moins égale au temps de balayage de la surface d'interaction par une onde élastique, d'amplitude constante, qui peut être par exemple égale à l'unité. Le signal de sortie $L_L$ est comme précédemment et avec les mêmes règles de sélection, par exemple recueilli entre les électrodes 3 et 4:

$$S_L\propto e^{i(\omega_N+\omega_P)t}\iint S(x,\ y)\ .\ e^{i(\vec{K}_N\pm\vec{K}_P\pm\vec{K})\vec{r}}\ .\ d^2r$$

Il s'agit d'un point de la transformée de Fourier bidimensionnelle du signal S(x, y). Pour obtenir un autre point de cette transformée il suffit de recommencer l'opération de lecture avec des valeurs différentes de $\omega_N$ et $\omega_P$. On obtient ainsi le balayage de tout l'espace transformée de Fourier.

Toutefois, le signal électrique disponible entre les électrodes 3 et 4 ne représente l'information utile que lorsque les ondes élastiques recouvrent toute la zone d'interaction: il ne doit alors bien entendu être prélevé qu'à ce moment-là. Il apparaît en outre ici un autre inconvénient de ce mode de lecture: pour traiter un autre point de la transformée, il faut attendre que les ondes de lecture aient disparu de la surface d'interaction et que de nouvelles ondes de lecture de pulsation différentes occupent toute cette surface, ce qui est égal au temps de parcours de toute la surface d'interaction par une onde élastique.

Pour pallier ce défaut, dans une variante, on reprend le signal précédemment mémorisé $S_M$, mais on utilise quatre signaux de lecture f, g, h et r, appliqués respectivement aux quatre transducteurs $T_1\ldots T_4$, qui sont des rampes de fréquence, c'est-à-dire des signaux dont la fréquence varie linéairement avec le temps:

$$\text{—sur } T_1{:}S_1=e^{j\alpha_1t^2}\cdot e^{j\omega_1t}$$

$$\text{—sur } T_2{:}S_2=e^{j\alpha_2(t-\theta)^2}\cdot e^{j\omega_2t}$$

$$\text{—sur } T_3{:}S_3=e^{-j\alpha_1't^2}\cdot e^{j\omega_1t}$$

$$\text{—sur } T_4{:}S_4=e^{-j\alpha_2'(t-\theta)^2}\cdot e^{j\omega_2t}$$

$\alpha_1$, $\alpha_1'$, $\alpha_2$ et $\alpha_2'$ étant des coefficients de proportionalité.

L'interaction de ces ondes produit des effets non linéaires parmi lesquels on considère deux du quatrième ordre, comme décrit dans la demande de brevet français n° 78-26817 au nom de Thomson-CSF (=EP—A—9436). Dans cette demande, il est notamment montré que cette interaction donne naissance à un signal ($S_L$) de pulsation $2(\omega_1+\omega_2)$ et le nombre d'onde nul, qu'il est possible de recueillir entre les électrodes 3 et 4, un filtre de sortie centré sur la fréquence

$$\frac{\omega_1+\omega_2}{\pi}$$

permettant d'isoler le signal utile. Le signal de sortie $S_L$ correspondant à toute la zone d'interaction ABCD s'écrit alors, si on choisit $\alpha_1=\alpha_1'$ et $\alpha_2=\alpha_2'$

$$S_L=e^{2j(\omega_1+\omega_2)t}\cdot\iint_{ABCD}S(x,y)\,.\,\exp\{-4j(\frac{\alpha_1 t}{V_x}x+\frac{\alpha_2(t-\theta)}{V_y}y)\}\,.\,dx;\,dy$$

Si on désigne par $K_1$ la quantité

$$4\frac{\alpha_1 t}{V_s}$$

et par $K_2$ la quantité

$$\frac{4\alpha_2}{V_y}(t-\theta)$$

on voit que l'expression sous l'intégrale est la transformée de Fourier du signal S:

$$J(K_1,K_2)=\iint_{ABCD}S(x,y)\,.\,e^{-j(K_1x+K_2y)}ds\,.\,dy$$

d'où

$$S_L=\exp\{2j(\omega_1+\omega_2)t\}\,.\,J[\frac{4\alpha_1 t}{V_x}x,\ \frac{4\alpha_2(t-\theta)}{V_y}]y$$

On obtient ici, de façon analogue au premier mode de mise en oeuvre mais dans l'espace transformée de Fourier, un balayage selon une ligne à une vitesse liée à $\alpha_1$ et $\alpha_2$; une trame de N lignes parallèles est obtenue comme précédemment en opérant N balayages successifs, soit avec N valeurs différentes du retard $\theta$, soit avec N valeurs différentes des fréquences des signaux.

Par rapport à la variante décrite ci-cessus, la rapidité de lecture est grandement accrue. En effet, il n'est plus nécessaire d'attendre le temps T mentionné plus haut pour lire un deuxième point de la transformée de Fourier: un temps 1/B, où B est la bande passange du système, est ici suffisant; cela veut dire que la lecture est B.T fois plus rapide, BT étant par ailleurs égal au nombre de points indépendants résolvables d'une ligne de l'image.

Un autre avantage de cette seconde variante tient au fait que la pente de la ligne de balayage dépend des coefficients $\alpha_1$ et $\alpha_2$, et plus précisément du rapport $\alpha_1/\alpha_2$. Il est donc possible de réaliser électroniquement une rotation quelconque de l'image par le choix du rapport $\alpha_1/\alpha_2$.

Lorsqu'on ne désire par faire subir de rotation à l'image. on choisit $\alpha_1$ assez élevé et $\alpha_2$ faible afin que les fréquences des signaux $S_2$ et $S_4$, qui sont fonction de $\alpha_2$, puissent être considérées comme constantes pendant le temps de balayage d'une ligne.

Cette variante qui utilise quatre rampes de fréquence à la lecture présente toutefois l'inconvénient de faire appel à une interaction non linéaire du quatrième ordre. Selon une troisième variante, pour pouvoir utiliser une interaction non linéaire du troisième ordre seulement, on modifie la phase d'écriture du signal S(t) en modulant préalablement ce dernier par une rampe de fréquence.

Dans ce cas, le signal à mémoriser étant toujours supposé porté par une onde de pulsation $\omega_s$, le signal appliqué à une des entrées du dispositif est de la forme:

$$S_1=S(t)\,.\,e^{1\omega_s t+1\alpha t^2}$$

$\alpha$ étant un coefficient de proportionalité.

L'une quelconque des variantes d'écriture décrites ci-dessus peut être utilisée. A titre d'exemple, on suppose que:

— le signal $S_1=S(t)e^{i\alpha t^2+i\omega_s t}$ est appliqué au transducteur $T_1$;
— le signal $U.\delta(t).e^{i\omega_u t}$ est appliqué au transducteur $T_2$, et
— le signal $W.\delta(t-\tau).e^{i\omega_w t}$ est appliqué aux électrodes 3—4.

Le signal mémorisé sur la ligne d'équation $y=v_y\tau$, est alors de la forme

$$S(-\frac{x}{v_x}, \tau)e^{i\alpha(\frac{x}{v_x})^2}$$

d'après la formule (3) et en négligeant le potentiel de polarisation.

Les signaux s'inscrivent comme précédemment en lignes parallèles à la précédente, en faisant varier le retard $\tau$ de W par rapport à U; les signal $S_M$ mémorisé sur l'ensemble de la surface d'interaction s'écrit:

$$S_M=S(-\frac{x}{v_x}, -\frac{y}{v_y}).e^{i\alpha(\frac{x}{v_x})^2}.\cos\vec{K}.\vec{r}$$

Lors de la lecture, on utilise comme précédemment deux signaux auxiliaires longs N(t) et P(t) dont un est également modulé linéairement en fréquence, avec le même coefficient $\alpha$.

On applique par exemple:

— au transducteur $T_1$ les signal $N.e^{i\omega_N t+i\alpha t^2}$
— au transducteur $T_2$ le signal $P.e^{i\omega_P t}$

Le signal $S_L$ de sortie est alors recueilli entre les électrodes 3 et 4.
Le calcul montre que, à un instant t, le signal $S_L(t)$ est de la forme:

$$S_L(t)=e^{i(\omega_N+\omega_P)t+i\alpha t^2}\iint S(x,y).e^{-2i\alpha t\frac{x}{v_x}-\frac{i\omega_P-\omega_u}{v_y}.y}\,dx.dy$$

si $\omega_P=\omega_S$.

Il s'agit d'une ligne

$$k_y=\frac{\omega_P-\omega_u}{v_y}$$

de la transformée de Fourier bidimensionnelle de S(x, y).

Selon une quatrième variante, on peut utiliser pour la phase de lecture une interaction du second ordre seulement, de façon analogue à ce qui vient d'être décrit. Pour cela, on module linéairement en fréquence deux des trois signaux utilisés à l'écriture, par exemple S(t) et U(t). La lecture se fait alors, comme précédemment, à l'aide de deux signaux longs N(t) et P(t), mais tous les deux modulés linéairement en fréquence, avec les mêmes coefficients que deux qui ont été utilisés à l'écriture.

A titre d'exemple, il a été réalisé un dispositif selon l'invention dans lequel ont été utilisées des impulsions de Dirac d'une durée de 30 ns, des dondes porteuses de fréquence 100 MHz pour U, 150 MHz pour W et 250 MHz pour le signal S(t) si on prend pour règle de sélection (4) le mode somme, c'est-à-dire $\omega_s=\omega_u+\omega_w$; si on choisit le mode différence, c'est-à-dire $\omega_s=\omega_u-\omega_w$, les fréquences sont alors, ;our U: 250 MHz et pour W: 100 MHz, ce qui donne 150 MHz pour S. Les dimensions de la zone d'intersection 5 des ondes (sur la figure 2) sont de 100 $\mu$m×100 $\mu$m, ce qui conduit pour une zone d'interaction de 1 cm×1 cm à $10^4$ points-mémoire.

**Revendications**

1. Dispositif acousto-électrique à deux dimensions pour la mémorisation et le traitement d'information, comportant:

— un milieu piézoélectrique (1), portant au moins deux transducteurs électro-mécaniques ($T_1$—$T_4$), susceptibles d'émettre des ondes élastiques à la surface du milieu piézoélectrique;
— un milieu électriquement non linéaire (2), said lequel sont susceptibles de se produire des interactions non linéaires entre les champs électriques associés aux ondes élastiques se propageant sur le milieu piézoélectrique;
— un milieu de stockage de charges électriques, ce milieu étant électriquement couplé au milieu non linéaire et susceptible de mettre en mémoire un signal analogique;
— un dispositif d'application et de prélèvement d'un signal électrique;

ce dispositif étant caractérisé par le fait que la mise en mémoire d'un signal analogique d'entrée (S(t)) est réalisée à l'aide de deux signaux auxiliaires d'écriture (U(t), W(t)), deux de ces trois signaux (S(t), U(t), W(t)) étant appliqués sur deux transducteurs électro-mécaniques qui émettent des ondes élastiques dans deux directions distinctes (Ox et Oy) à l'exclusion des sens opposés et l'autre signal étant appliqué sur un troisième transducteur électromécanique ou sur le dispositif (3, 4) d'application d'un signal électrique qui agit sur la surface d'interaction, les fréquences des signaux auxiliaires étant telles que l'interaction non linéaire des trois signaux fournisse un signal ($S_M$) représentant le signal d'entrée (S(t)), indépendant du temps, sous forme d'une distribution spatiale périodique de charges électriques, stockées dans le milieu de stockage, les deux signaux auxiliaires d'écriture (U(t), W(t)) étant des trains d'impulsions, d'amplitude supérieure à celle du signal d'entrée (S(t)), la surface d'intersection de ces deux impulsions définissant une zone élémentaire d'interaction (5), ces impulsions étant émises avec une période au moins égale au temps de balayage de la surface d'interaction par la zone élémentaire, et des retards relatifs ($\tau$) variables, assurant le balayage en lignes (L) de la surface d'interaction par la zone élémentaire (5) et par suite le stockage en lignes du signal $S_M$ résultant des interactions non linéaires successives.

2. Dispositif selon la revendication 1, caractérisé par le fait que les deux directions sont normales entre elles.

3. Dispositif selon la revendication 1, caractérisé par le fait que les deux signaux auxiliaires d'écriture (U(t), W(t)) sont appliqués respectivement aux deux transducteurs électro-mécaniques ($T_1$, $T_2$) et le signal d'entrée (S(t)) est appliqué entre deux électrodes continues (3, 4) d'un dispositif d'application d'un signal électrique.

4. Dispositif selon la revendication 1, caractérisé par le fait qu'un troisième transducteur et l'un des deux dits transducteurs électromécaniques ($T_3$) émettent des ondes élastiques à la surface du milieu piézoélectrique dans de des sens opposés et que le deux signaux auxiliaires d'écriture (U(t), W(t)) sont appliqués respectivement aux deux dits transducteurs ($T_1$, $T_2$) et que le signal d'entrée (S(t)) est appliqué au troisième transducteur ($T_3$).

5. Dispositif selon la revendication 1 caractérisé par le fait que l'un (W(t)) des signaux d'écriture est appliqué entre deux électrodes continues (3, 4) du dispositif d'application d'un signal électrique, et que l'autre (U(t)) des signaux d'écriture et le signal d'entrée S(t) sont appliqués respectivement aux deux transducteurs électro-mécaniques ($T_1$, $T_2$).

6. Dispositif selon l'une des revendications précédentes, caractérisé par le fait que la lecture du signal stocké ($S_M$) est réalisée à l'aide de deux ondes auxiliaires de lecture (N, P), qui sont émises dans deux directions distinctes à l'exclusion des sens opposés et dont les fréquences ($\omega_N$, $\omega_P$) sont telles que l'interaction non linéaire du signal stocké ($S_M$) et des deux ondes auxiliaires de lecture (N, P) fournisse un signal de sortie ($S_L$) dont le nombre d'ondes ($K_L$) corresponde à la périodicité (P) d'un dispositif captant ce signal, les deux signaux auxiliaires de lecture (N, P) étant des trans d'impulsions, la surface d'intersection de ces deux impulsions définissant une zone élémentaire d'interaction (5), ces impulsions étant émises avec une période au moins égale au temps de balayage de la surface d'interaction par la zone élémentaire, et des retards relatifs ($\tau$) variables, assurant le balayage en lignes (L) de la surface d'interaction par la zone élémentaire (5).

7. Dispositif selon la revendication 6, caractérisé par le fait que les deux ondes auxiliaire de lecture (N(t), P(t)) sont appliquées respectivement aux deux transducteurs électro-mécaniques ($T_1$, $T_2$), le signal de sortie ($S_L$) étant prélevé entre deux électrodes (3, 4) du dispositif de prélèvement.

8. Dispositif selon l'une des revendications 1 à 5, caractérisé par le fait que la lecture du signal stocké ($S_M$) est réalisée à l'aide de deux ondes auxiliaires longues de lecture (N(t), P(t)), qui sont émises dans deux directions distinctes à l'exclusion des sens opposés et dont la durée est au moins égale au temps de balayage de la surface d'interaction par une onde élastique, et dont les fréquences sont telles que l'interaction non linéaire du signal stocké ($S_M$) et des deux ondes auxiliaires de lecture (N, P) fournisse un signal de sortie ($S_L$) dont le nombre d'onde corresponde à la périodicité d'un dispositif captant ce signal, cette interaction fournissant un point de la transformée de Fourier du signal d'entrée (S(t)), les autres points de la transformée étant fournis par la variation des fréquences des ondes auxiliaires de lecture.

9. Dispositif selon l'une des revendications 1 à 5, caractérisé par le fiat que la lecture du signal stocké ($S_M$) est réalisée à l'aide de quatre ondes auxiliaires de lecture ($S_1 \ldots S_4$) linéairement modulées en fréquence, émises dans un premier et deuxième sens (Ox, Oy) et dans un troisième et quatrième sens (—Ox, —Oy) qui ont même direction mais de sens opposés aux premier et deuxième sens à la

surface du milieu piézoélectrique, les ondes émises dans les premier et troisième ainsi que dans les deuxième et quatrième sens ayant même fréquence ($\omega_1$ ou $\omega_2$) et des pentes de modulation opposées, des trains d'ondes étant émis dans les second et quatrième sens (Oy, —Oy) avec un retard ou un décalage de fréquence variable par rapport aux trains d'ondes émis dans les premier et troisième sens (Ox, —Ox), et que le dispositif de prélèvement (3, 4) d'un signal électrique dans le milieu non linéaire, assure le prélèvement du signal résultant de l'interaction des trans d'ondes précédents, qui représente, ligne après ligne, la transformée de Fourier du signal d'entrée (S(t)).

10. Dispositif selon l'une des revendications 1 à 5, caractérisé par le fait que le signal d'entrée (S(t)) est modulé linéairement en fréquence avant l'interaction non linéaire avec les deux signaux auxiliaires d'écriture (U(t), W(t)), et que la lecture du signal stocké ($S_M$) est réalisée à l'aide de deux ondes auxiliaires le lecture (N(t), P(t)) émises dans deux directions distinctes à l'exclusion des sens opposés, la première étant une onde longue, dont la durée est au moins égale au temps de balayage de la surface d'interaction par une onde élastique, la seconde étant une onde longue, sont la durée est au moins égale à la précédente, linéairement modulée en fréquence avec la même pente que le signal d'entrée (S(t)), les fréquences des ondes auxiliaire de lecture étant telles que l'interaction non linéaire du signal stocké ($S_M$) et des ondes auxiliaires de lecture (N, P) fournisse un signal de sortie ($S_L$) dont le nombre d'ondes corresponde à la périodicité d'un dispositif captant ce signal, le signal de sortie représentant une ligne de la transformée de Fourier du signal d'entrée (S(t)).

11. Dispositif selon l'une des revendications 1 à 5, caractérisé par le fait que le signal d'entrée (S(t)) et l'un des signaux auxiliaires d'écriture (U(t), W(t)) sont modulés linéairement en fréquence avant l'interaction non linéaire aved l'autre des signaux auxiliaires d'écriture, et que la lecture du signal stocké ($S_M$) est réalisée à l'aide de deux ondes auxiliaires de lecture (N(t), P(t)) émises dans deux directions distinctes à l'exclusion des sens opposés, linéairement modulées en fréquence avec les mémes pentes que celles des signaux auxiliaires d'écriture, dont les durées sont au moins égales au temps de balayage de la surface d'interaction par one onde élastique, les fréquences des signaux auxiliaires de lecture étant telles que l'interaction non linéaire du signal stocké ($S_M$) et des deux ondes auxiliaires de lecture (N, P) fournisse un signal de sortie ($S_L$) dont le nombre d'ondes corresponde à la périodicité d'un dispositif captant ce signal, le signal de sortie ($S_L$) représentant une ligne de la tranformée de Fourier du signal d'entrée (S(t)).

12. Dispositif selon la revendication 1, caractérisé par le fait que le milieu piézoélectrique est constitué par une première plaquette (1) et que le milieu non linéaire est constitué par une seconde plaquette (2) réalisée en un matériau semi-conducteur, les deux plaquettes étant séparées par une couche d'aire, les ondes élastiques se propageant sur une première face de la plaquette semi-conductrice (2), le dispositif d'application et de prélèvement d'un signal électrique étant constitué par des électrodes (3—4) placées respectivement sur les faces extérieures des deux plaquettes.

13. Dispositif selon la revendication 12, caractérisé par le fait que les électrodes sont continues.

14. Dispositif selon la revendication 12, caractérisé par le fait que le milieu de stockage est constitué par la plaquette semi-conductrice.

15. Dispositif selon la revendication 12, caractérisé par le fait que le milieu non linéaire et le milieu de stockage sont constitués par un même réseau de diodes PN ou Schottky ou d'éléments MIS ou MOS, réalisés dans la plaquette semi-conductrice sur la surface qui est vis-à-vis de la plaquette piézoélectrique.

16. Dispositif selon l'une des revendications 12 ou 15, caractérisé par le fait que le milieu de stockage comporte un réseau d'éléments mémoire.

**Patentansprüche**

1. Zweidimensionale akusto-elektrische Vorrichtung für die Speicherung und die Verarbeitung von Informationen, mit:

— einem piezoelektrischen Milieu (1), das mindestens zwei elektromechanische Transduktoren ($T_1$—$T_4$) trägt, die elastische Wellen an der Oberfläche des piezoelektrischen Milieus aussenden können,
— einem elektrisch nicht-linearen Milieu (2), in dem sich nichtlineare Interaktionen zwischen den zu den sich auf dem piezoelektrischen Milieu fortpflanzenden elastischen Wellen gehörenden elektrischen Felderns ergeben können,
— einem Speichermilieu für elektrische Ladungen, das elektrisch an das nicht-lineare Milieu gekoppelt ist und ein Analogsignal speichern kann,
— einer Vorrichtung zum Anlegen und zur Entnahme eines elektrischen Signals,

dadurch gekennzeichnet, daß die Speicherung eines analogen Eingangssignals (S(t)) mithilfe zweier Holfsschreibsignale (U(t)), W(t)) geschieht, wobei zwei dieser drei Signale (S(t), U(t), W(t)) an zwei elektromechanische Transduktoren angelegt werden, die elastische Wellen in zwei unterychiedliche Richtungen (Ox und Oy) aussenden, die einander nicht entgegengerichtet sind, und das andere Signal an einen dritten elektromechanischen Transduktor oder an die Vorrichtung (3, 4) zum Anlegen eines elektrischen Signals angelegt ist, das auf die Interaktionsoberfläche wirkt, wobei die Frequenzen der

Hilfssignale so gewählt sind, daß die nicht-lineare Interaktion der drei Signale ein Signal ($S_M$) ergibt, das das Eingangssignal (S(t)) unabhängig von der Zeit darstellt, in Form einer periodisch-räumlichen Verteilung von elektrischen Ladungen die im Speichermilieu gespeichert wind, wobei die beiden Hilfsschreibsignale (U(t), W(t)) Impulszüge einer größeren Amplitude als die des Eingangssignals (S(t)) sind und die Schnittfläche dieser beiden Impulse eine elementare Interaktionszone (5) bildet, wobei diese Impulse mit einer Periode ausgesandt werden, die mindestens bleich der Überstreichzeit der Interaktions-Oberfläche durch die elementare Zone ist, und mit veränderlichen Relativverzögerungen ($\tau$), wodurch das Überstreichen Zeile für Zeile (L) der Interaktions-Oberfläche durch die elementare Zone (5) und anschließend die Speicherung Zeile für Zeile des aus aufeinanderfolgenden nicht-linearen Interaktionene resultierenden Signals $S_M$ bewirkt werden.

2. Vorrichtung nach Anspruch 1, dadurch gekennzeichnet, daß die beiden Richtungen zueinander senkrecht verlaufen.

3. Vorrichtung nach Anspruch 1, dadurch gekennzeichnet, daß die beiden Hilfsschreibsignale (U(t), W(t)) je an die beiden elektro-mechanischen Transduktoren ($T_1$, $T_2$) angelegt werden und daß das Eingangssignal (S(t)) zwischen zwei kontinuierlichen Elektroden (3, 4) einer Vorrichtung zum Anlegen eines elektrischen Signals angelegt ist.

4. Vorrichtung nach Anspruch 1, dadurch gekennzeichnet, daß eine dritter Transduktor und einer der beiden elektromechanischen Transduktoren ($T_3$) elastische Wellen an der Oberfläche des piezoelektrischen Milieus in entgegengesetzte Richtungen aussenden, daß die beiden Hilfsschreibsignale (U(t), W(t)) je an einen der beiden Transduktoren ($T_1$, $T_2$) angelegt werden und daß das Eingangssignal (S(t)) an den dritten Transduktor ($T_3$) angelegt wird.

5. Virrichtung nach Anspruch 1, dadurch gekennzeichnet, daß eines der Schreibsignale (W(t) zwischen zwei kontinuierliche Elektroden (3, 4) der Vorrichtung zum Anlegen eines elektrischen Signals angelegt wird und daß das andere Schreibsignal (U(t)) und das Eingangssignal (S(t)) je an einen der beiden elektromechanischen Transduktoren ($T_1$, $T_2$) angelegt werden.

6. Vorrichtung nach einem der vorstehenden Ansprüche, dadurch gekennzeichnet, daß das Lesen des gespeicherten Sighals ($S_M$) mithilfe zweier Hilfslesewellen (N, P) erfolgt, die in zwei bestimmte Richtungen mit Ausnahme der einander entgegengesetzen Richtungen ausgesandt werden und deren Frequenzen ($\omega_N$, $\omega_P$) so gewählt sind, daß die nicht-lineare Interaktion des gespeicherten Signals ($S_M$) und der zwei Hilfslesewellen (N, P) ein Ausgangssignal ($S_L$) ergibt, dessen Anzahl von Wellen ($K_L$) der Periodizität (P) einer Vorrichtung entspricht, die dieses Signal auffängt, wobei die Hilfslesesignale (N, P) Impulszüge sind und die Schnittfläche dieser beiden Impulse eine elementare Interaktionszone (5) bildet, wobei diese Impulse mit einer Periode ausgesandt werden, die mindestens gleich der Überstreichzeit der Interaktions-Oberfläche durch die elementare Zone ist, und mit veränderlichen Relativ-Verzögerungen ($\tau$), wodurch das Überstreichen Zeile für Zeile (L) der Interaktions-Oberfläche durch die elementare Zone (5) bewirkt wird.

7. Vorrichtung nach Anspruch 6, dadurch gekennzeichnet, daß die beiden Hilfslesewellen (N(t), P(t)) je an einen der beiden elektromechanischen Transduktoren ($T_1$, $T_2$) angelegt werden, wobei das Ausgangssignal ($S_L$) zwischen zwei Elektroden (3, 4) der Vorrichtung zur Entnahme entnommen wird.

8. Vorrichtung nach einem der Ansprüche 1 bis 5, dadurch gekennzeichnet, daß das Lesen des gespeicherten Signals ($S_M$) mithilfe zweier langer Hilfslesewellen (N(t), P(t)) erfolgt, die in zwei bestimmte Richtungen mit Ausnahme der einander entgegengesetzten Richtungen ausgesandt werden und deren Dauer mindestens gleich der Überstreichzeit der Interaktions-Oberfläche durch eine elastische Welle ist und deren Frequenzen so gewählt sind, daß die nicht-lineare Interaktion des gespeicherten Signals ($S_M$) und der beiden Hilfslesewellen (N, P) ein Ausgangssignal ($S_L$) ergibt, dessen Wellenanzahl der Period izität einer dieses Signal auffangenden Vorrichtung entspricht, wobei diese Interaktion einen Punkt der Fourier-Transformation des Eingangssignals (S(t)) ergibt, während die anderen Punkte der Transformation von der Frequenzvariation der Hilfslesewellen geliefert werden.

9. Vorrichtung nach einem der Ansprüche 1 bis 5, dadurch gekennzeichnet, daß das Lesen des gespeicherten Signals ($S_M$) mithilfe von vier linear frequenzmodulierten Hilfslesewellen ($S_1 \ldots S_4$) erfolgt, die in einer ersten und zweiten Richtung (Ox, Oy) und einer dritten und vierten Richtung (—Ox, —Oy) ausgesandt werden, wobei die letzteren Richtungen den ersteren je an der Oberfläche des piezoelektrischen Milieus entgegengerichtet sind und die in der ersten und der dritten Richtung bzw. die in der zweiten und vierten Richtung ausgesandten Wellen dieselbe Frequenz ($\omega_1$ oder $\omega_2$) und entgegengesetzte Modulationsflanken besitzen und wobei die Wellenzüge in der zweiten und vierten Richtung (Oy, —Oy) mit einer variablen Verzögerung oder Frequenzverschiebung bezüglich der in der ersten und der dritten Richtung (Ox, —Ox) ausgesandten Wellenzüge ausgesandt werden, und daß die Vorrichtung (3, 4) zur Entnahme eines Signals im nicht-linearen Milieu die Entnahme des Signals bewirkt, das von der Interaktion der vorgenannten Wellenzüge stammt und das Zeile für Zeile die Fouriertransformation des Eingangssignals (S(t)) wiedergibt.

10. Vorrichtung nach einem der Ansprüche 1 bis 5, dadurch gekennzeichnet, daß das Eingangssignal (S(t)) vor der nichtlinearen Interaktion mit den beiden Hilfsschreibsignalen (U(t), W(t)) linear frequenzmoduliert wird und daß das Auslesen des gespeicherten Signals ($S_M$) mithilfe von zwei Hilfslesewellen (N(t), P(t)) erfolgt, die in zwei bestimmten, aber einander nicht entgegengesetzten Richtungen ausgesandt werden, wobei die erste Welle eine lange Welle ist, deren Dauer mindestens

gleich der Überstreichungszeit der Interaktionsoberfläche durch eine elastische Welle ist, während die zweite Welle eine lange Welle ist, deren Dauer mindestens gleich der vorhergehenden Welle ist, die linear frequenzmoduliert ist, mit derselben Modulationsflanke wie das Eingangssignal (S(t)), wobei die Frequenzen der Hilfslesewellen so gewählt sind, daß die nichtlineare Interaktion des gespeicherten Signals ($S_M$) und der Hilfslesewellen (N, P) ein Ausgangssignal ($S_L$) ergibt, dessen Wellenanzahl der Periodizität einer dieses Signal auffangenden Vorrichtung entspricht, und wobei das Ausgangssignal eine Zeile der Fourier-Transformation des Eingangssignals (S(t)) wiedergibt.

11. Vorrichtung nach einem der Ansprüche 1 bis 5, dadurch gekennzeichnet, daß das Eingangssignal (S(t)) und eines der Hilfsschreibsignale (U(t), W(t)) vor der nicht-linearen Interaktion mit dem anderen Hilfsschreibsignal linear frequenzmoduliert wird und daß das Auslesen des gespeicherten Signals ($S_M$) mithilfe von zwei Hilfslesewellen (N(t), P(t)) erfolgt, die in zwei bestimmten, aber einander nicht entgegengesetzten Richtungen ausgesandt werden, die frequenzmoduliert sind mit denselben Flanken wie die Hilfsschreibsignale und deren Dauer mindestens der Überstreichungszeit der Interaktionsoberflächen durch eine Elastische Welle gleicht, wobei die Frequenzen der Hilfslesesignale so gewählt sind, daß die Nicht-lineare Interaktion des gespeicherten Signals ($S_M$) und der beiden Hilfslesewellen (N, P) ein Ausgangssignal ($S_L$) ergibt, dessen Wellenanzahl der Periodizität einer dieses Signal auffangenden Vorrichtung entspricht, und wobei das Ausgangssignal ($S_L$) eine Zeile der Fourier-Transformation des Eingangssignals (S(t)) wiedergibt.

12. Vorrichtung nach Anspruch 1, dadurch gekennzeichnet, daß das piezoelektrische Milieu aus einem ersten Plättschen (1) und das nicht-lineare Milieu aus einem zweiten Plättchen (2) aus einem halbleitenden Material besteht, wobei die beiden Plättchen durch eine Luftschicht voneinander getrennt sind und sich die elastischen Wellen auf einer ersten Fläche des halbleitenden Plättchens (2) fortpflanzen und wobei die Vorrichtung zum Anlegen und zur Entnahme eines elektrischen Signals aus Elektroden (3—4) besteht, die je auf einer der Außenflächen der beiden Plättchen angeordnet sind.

13. Vorrichtung nach Anspruch 12, dadurch gekennzeichnet, daß die Elektroden kontinuierlich sind.

14. Vorrichtung nach Anspruch 12, dadurch gekennzeichnet, daß das Speichermilieu von dem halbleitenden Plättchen gebildet wird.

15. Vorrichtung nach Anspruch 12, dadurch gekennzeichnet, daß das nicht-lineare Milieu und das Speichermilieu aus ein- und demselben Netz von PN-Dioden oder Schottky-Dioden oder MIS-Elementen oder MOS-Elementen besteht, die in den halbleitenden Plättchen auf der Fläche ausgebildet sind, welche dem piezoelektrischen Plättchen gegenüberliegt.

16. Vorrichtung nach einem der Ansprüche 12 oder 15, dadurch gekennzeichnet, daß das Speichermilieu ein Netz von Speicherelementen aufweist.

**Claims**

1. A bidimensional acusto-electric device for memorizing and treating informations, comprising

— a piezoelectric medium (1) bearing at least two electromechanical transducers ($T_1$—$T_4$) which are able to send out elastical waves at the surface of the piezoelectric medium,
— an electrically nonlinear medium (2), in which nonlinear interactions may occur between the electric fields associated to the elastical waves which propagate on the piezoelectric medium,
— a memory medium for electric charges which medium is electrically coupled to the nonlinear medium and is able to memorize an analog signal,
— a device for applying and sampling an electric signal,

characterized in that the memorization of an analog input signal (S(t)) is obtained by means of two auxiliary write signals (U(t), W(t)), two of these three signals (S(t), U(t), W(t)) being applied to two electromechanical transducers which send out elastic waves into two distinct directions (Ox and Oy) except the mutually opposed directions, whereas the other signal is applied to a third electromechanical transducer or to the device (3, 4) for applying an electric signal which acts on the interaction surface, the frequencies of the auxiliary signals being chosen such that the nonlinear interaction of the three signals furnishes a signal ($S_M$) which represents the input signal (S(t)) independently of the time, having the shape of a periodical spatial distribution of electric charges which are stocked in the memory medium, the two auxiliary write signals (U(t), W(t)) being pulse trains of a higher amplitude as the input signal (S(t)), and the intersection surface of these two pulses defining an elementary interaction zone (5), these pulses being sent out with a period which is at least equal to the scanning time of the interaction surface by the elementary zone, and with variable relative delays ($\tau$), thus ensuring the scanning, line by line (L), of the interaction surface by the elementary zone (5) and consequently the stocking line by line of the signal ($S_M$) resulting from successive nonlinear interactions.

2. A device according to Claim 1, characterized in that the two directions are perpendicular to each other.

3. A device according to Claim 1, characterized in that the two auxiliary write signals (U(t), W(t))

are applied respectively to the two electromechanical transducers ($T_1$, $T_2$) and the input signal (S(t)) is applied between two continuous electrodes (3, 4) of a device for applying an electric signal.

4. A device according to Claim 1, characterized in that a third transducer and one of said two electromechanical transducers ($T_3$) send out elastical waves at the surface of the piezoelectric medium in opposite directions, and that the two auxiliary write signals (U(t)), W(t)) are applied respectively to said two transducers and that the input signal (S(t)) is applied to the third transducer ($T_3$).

5. A device according to Claim 1, characterized in that one of the wrire signals (W(t)) is applied between two continuous electrodes (3, 4) of the device for applying an electric signal, and that the other write signal (U(t)) and the input signal (S(t)) are applied respectively to the two electromechanical transducers ($T_1$, $T_2$).

6. A device according to one of the preceding claims, characterized in that the reading of the memorized signal ($S_M$) is realized by means of two auxiliary read waves (N, P) which are sent out in two distinct directions, except the mutually opposed directions, and the frequencies ($\omega_M$, $\omega_P$) of which are chosen in such a way that the nonlinear interaction of the memorized signal ($S_M$) and of the two auxiliary read waves (N, P) furnishes an output signal ($S_L$), the number of waves ($K_L$) of which corresponds to the periodicity (P) of a device receiving this signal, the two auxiliary read signals (N, P) being constituted by pulse trains, the intersection surface of these two pulses defining an elementary interaction zone (5), these pulses being sent out with a period which is at least equal to the scanning time of the interaction surface by the elementary zone, and with variable relative delays ($\tau$) ensuring the scanning, line by line (L), of the interaction surface by the elementary zone (5).

7. A device according to Claim 6, characterized in that the two auxiliary read waves (N(t), P(t)) are applied respectively to the two electromechanical transducers ($T_1$, $T_2$), the output signal ($S_L$) being taken between two electrodes (3, 4) of the sampling device.

8. A device according to one of the Claims 1 to 5, characterized in that the memorized signal ($S_M$) is read by means of two long auxiliary read waves (N(t), P(t)) which are sent out into two distinct directions except the mutually opposed directions, and the time duration of which is at least equal to the scanning time of the interaction surface by an elastical wave, and the frequencies of which are chosen such that the nonlinear interaction of the memorized signal ($S_M$) and of the two auxiliary read signals (N, P) furnishes an output signal ($S_L$), the number of waves of which corresponds to the periodicity of a device receiving said signal, this interaction furnishing a point of the Fourier transformation of the input signal (S(t)), the other points of said transformation being furnished by the variation of the frequencies of the auxiliary read waves.

9. A device according to one of the Claims 1 to 5, characterized in that the memorized signal ($S_M$) is read by means of four linearily frequency modulated auxiliary read waves ($S_1 \ldots S_4$) which are sent out in a first and a second direction (Ox, Oy) and in a third and a fourth direction (—Ox, —Oy) which are opposite to the first and second directions at the surface of the piezoelectric medium, the waves sent out into the first and third directions as well as the waves sent out into the second and fourth directions having the same frequency ($\omega_1$ and $\omega_2$) and opposite modulation slopes, wave trains being sent out into the second and fourth direction (Oy, —Oy) with a variable delay or frequency shift with respect to the wave trains sent out into the first and the third directions (Ox, —Ox), and that the device (3, 4) for sampling an electric signal in the nonlinear medium ensures the sampling of the signal which results from the interaction of the preceding wave trains and which represents, line after line, the Fourier transformation of the input signal (S(t)).

10. A device according to one of the Claims 1 to 5, characterized in that the input signal (S(t)) is linearily frequency modulated prior to the nonlinear interaction with the two auxiliary write signals (U(t), W(t)), and that the memorized signal ($S_M$) is read by means of the two auxiliary read waves (N(t), P(t)) which are sent out into two distinct directions except the mutually opposed directions, the first being a long wave, the duration of which is at least equal to the scanning time of the interaction surface by an elastic wave, whereas the second is a long wave, the duration of which is at least equal to the preceding wave and which is linearily frequency modulated with the same slope as the input signal (S(t)), the frequencies of the auxiliary read waves being such that the nonlinear interaction of the memorized signal ($S_M$) and of the auxiliary read signals (N, P) furnishes an output signal ($S_L$), the number of waves of which corresponds to the periodicity of a device receiving said signal, the output signal representing a line of the Fourier transformation of the input signal.

11. A device according to one of the Claims 1 to 5, characterized in that the input signal (S(t)) and one of the auxiliary write signals (U(t), W(t)) are linearily frequency modulated prior to the nonlinear interaction with the other auxiliary write signal, and that the memorized signal ($S_M$) is read by means of two auxiliary read waves (N(t), P(t)) which are sent out into two distinct directions except the mutually opposed directions and which are linearily frequency modulated with the same slopes as the auxiliary write signals, and the durations of which are at least equal to the scanning time of the interaction surface by an elastical wave, the frequencies of the auxiliary read signals being chosen such that the nonlinear interaction of the memorized signal ($S_M$) and of the two auxiliary read signals (N, P) furnishes an output signal ($S_L$), the number of waves of which corresponds to the periodicity of a device receiving said signal, the output signal ($S_L$) representing a line of the Fourier transformation of the input signal (S(t)).

12. A device according to Claim 1, characterized in that the piezoelectric medium is constituted by a first plate (1) and that the nonlinear medium is constituted by a second plate (2) made from a semiconductor material, the two plates being separated by an air layer, the elastical waves propagating on a first face of the semiconductor plate (2), the device for applying and sampling an electric signal being constituted by electrodes (3, 4), placed respectively on the exterior faces of the two plates.

13. A device according to Claim 12, characterized in that the electrodes are continuous electrodes.

14. A device according to Claim 12, characterized in that the memory medium is constituted by the semiconductor plate.

15. A device according to Claim 12, characterized in that the nonlinear medium and the memory medium are constituted by the same network made of PN diodes or of Schottky diodes or of MIS elements or of MOS elements, realized in a semiconductor plate the surface of which faces the piezoelectric plate.

16. A device according to one of the Claims 12 to 15, characterized in that the memory medium comprises a network of memory elements.

FIG_1

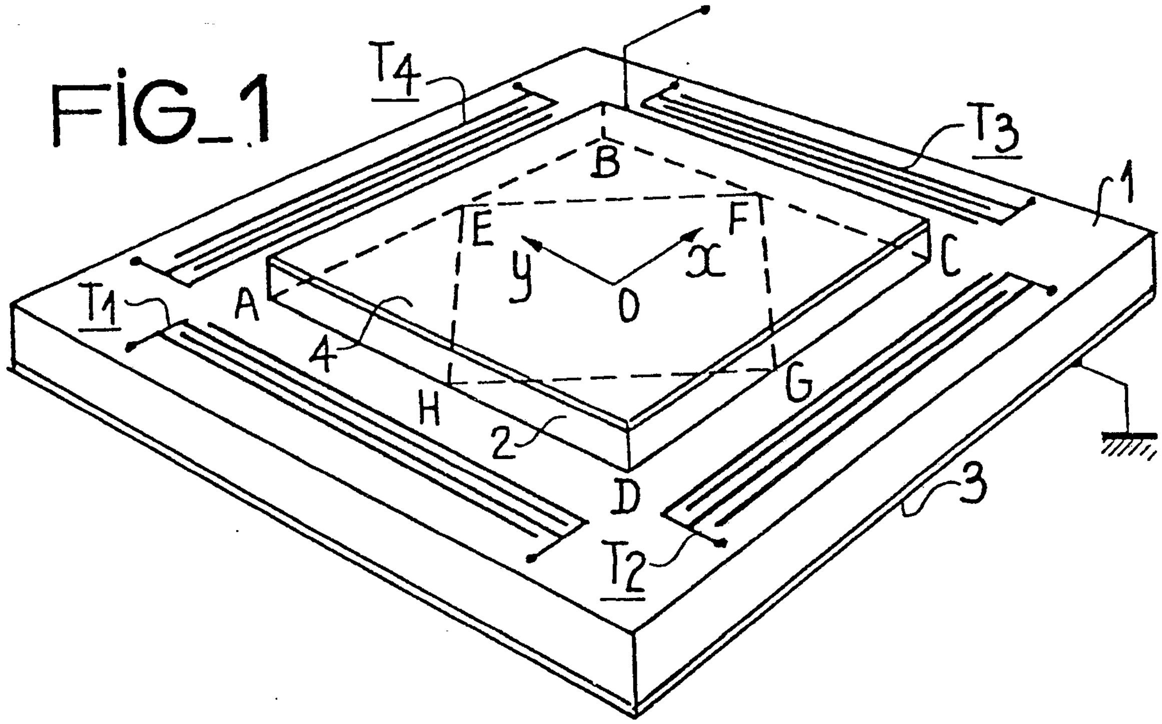


FIG_2

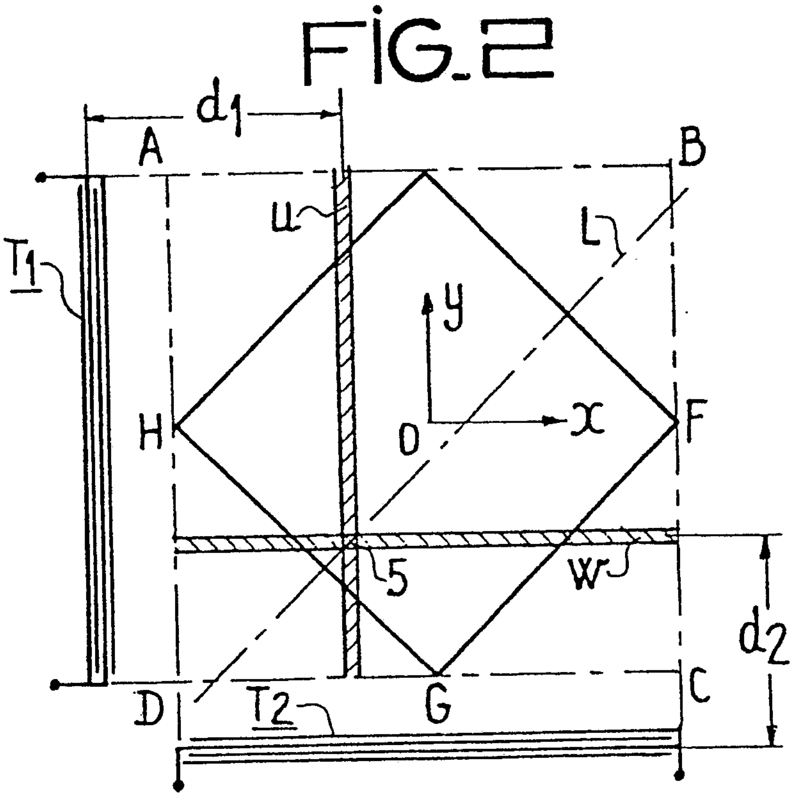


FIG_3